# FASCICULE DE BREVET EUROPEEN

(11) **EP 2 441 090 B1**
(45) Date de publication et mention de la délivrance du brevet: **26.02.2014**
(21) Numéro de dépôt: 10725153.0
(22) Date de dépôt: 11.06.2010
(51) Int. Cl.: H01L 23/522, H01L 23/525, H01L 23/62, H01L 23/48, H01L 21/768

(54) **DISPOSITIF MICROELECTRONIQUE DOTE D'UNE MATRICE D'ELEMENTS A BASE D'UN POLYMERE CONDUCTEUR A COEFFICIENT DE TEMPERATURE POSITIF**
MIKROELEKTRONISCHE VORRICHTUNG MIT EINER ANORDNUNG AUS ELEMENTEN AUS EINEM LEITENDEN POLYMER MIT POSITIVEM TEMPERATURKOEFFIZIENT
MICROELECTRONIC DEVICE PROVIDED WITH AN ARRAY OF ELEMENTS MADE FROM A CONDUCTIVE POLYMER WITH A POSITIVE TEMPERATURE COEFFICIENT

(30) Priorité: 11.06.2009 FR 0953908
(43) Date de publication de la demande: 18.04.2012
(73) Titulaire: Commissariat à l'Énergie Atomique et aux Énergies Alternatives, 75015 Paris (FR)
(72) Inventeur: LOUIS, Didier, F-38500 Coublevie (FR); DU PORT DE PONCHARRA, Jean, F-38950 Quaix En Chartreuse (FR)
(74) Mandataire: Ilgart, Jean-Christophe
(86) Numéro de dépôt international: PCT/EP2010/058252
(87) Numéro de publication internationale: WO 2010/142793

(56) Documents cités:
- WO-A2-02/091496
- WO-A2-2008/091648
- US-A1- 2004 166 669
- US-A1- 2009 009 926
- US-B1- 6 249 038
- OWEN F: "Protect your circuits" SENSORS, NORTH AMERICAN TECHNOLOGY, PETERBOROUGH, NH, US, vol. 18, no. 3, 1 mars 2001 (2001-03-01), pages 62-70, XP008117093 ISSN: 0746-9462
- KINSMAN K: "PPTC offers new option for circuit protection" PCIM POWER ELECTRONIC SYSTEMS, INTERTEC INTERNATIONAL, VENTURA, CA, US, vol. 29, no. 7, 1 juillet 2003 (2003-07-01), pages 52-54, XP008117091 ISSN: 1523-4908
- KATAOKA M ET AL: "PTC characteristics of (TiC/polyethylene ) conductive composites in relation to their particle-filled structures" TRANSACTIONS OF THE INSTITUTE OF ELECTRICAL ENGINEERS OF JAPAN, PART A INST. ELECTR. ENG. JAPAN, vol. 124-A, no. 4, avril 2004 (2004-04), pages 337-343, XP002563243 ISSN: 0385-4205
- CHIUNG-CHIH LIN ET AL: "A varistor-polymer composite with nonlinear electrical-thermal switching properties" CERAMICS INTERNATIONAL PUBLISHED ON BEHALF ON TECHNA S.R.L. BY ELSEVIER SCIENCE LTD. UK, vol. 34, no. 1, janvier 2008 (2008-01), pages 131-136, XP002563242 ISSN: 0272-8842

## Description

### DOMAINE TECHNIQUE

L'invention concerne le domaine de la microélectronique et des circuits intégrés.

Elle prévoit la réalisation d'un dispositif microélectronique comportant un ou plusieurs circuits électroniques et des éléments d'interconnexion formant au moins un via destiné à connecter des niveaux métalliques entre eux et à véhiculer un courant électrique.

Ces éléments d'interconnexion comportent un matériau particulier pour former des moyens de protection contre des surintensités ou des phénomènes d'échauffement dans le dispositif.

### ART ANTERIEUR

Le document : « Low-resistance, power saving, miniature type polymer PTC thermistors » provenant de la société TDK et datant d'octobre 2003, présente un dispositif électronique doté d'une couche de polymère conducteur CTP (CTP pour « coefficient de température positif ») située entre des électrodes et servant de protection contre des surintensités ou des surchauffes.

Dans le domaine de la microélectronique, les dispositifs microélectronique sont généralement dotés d'un ou plusieurs circuits intégrés comprenant un ou plusieurs niveaux d'interconnexions métalliques, formés de lignes conductrices horizontales reliées entre elles par des éléments conducteurs verticaux également appelés « vias ».

Dans ce domaine, des systèmes apportant une protection aux circuits intégrés contre des conditions de surintensité ou de surchauffe, sont connus.

Parmi ces systèmes figurent des fusibles intégrés à action unique, qui, la plupart du temps, sont détruits après une seule utilisation, c'est-à-dire dès lorsqu'une surintensité survient.

Il se pose le problème de trouver un nouveau moyen de protection contre des surintensités intégré dans un dispositif microélectronique doté d'un ou plusieurs circuits intégrés, qui ne soit pas limité à une utilisation unique, et qui réponde à des critères de faible encombrement et de faible coût de mise en oeuvre.

Un dispositif semi-conducteur comprenant un élément d'interconnexion à base d'un matériau polymère conducteur à coefficient de température positif est décrit dans le document US-A-2004/166 669.

### EXPOSÉ DE L'INVENTION

L'invention concerne tout d'abord un procédé de réalisation d'un dispositif microélectronique comprenant sa fabrication par :
a) réalisation sur un substrat d'un ou plusieurs composants d'au moins un circuit électronique et d'un ou plusieurs niveaux métalliques d'interconnexion du circuit électronique dans au moins une couche isolante,
b) réalisation d'une pluralité d'éléments d'interconnexions orthogonaux au plan principal du substrat, traversant ladite couche isolante, lesdits éléments étant à base d'un matériau polymère conducteur à coefficient de température positif.

Les éléments d'interconnexion à base d'un matériau polymère conducteur à coefficient de température positif forment des moyens de protection, à utilisations multiples, à la fois contre des surintensités, et contre une surchauffe du dispositif.

Ces éléments d'interconnexion peuvent ainsi jouer le rôle de fusibles, thermiques et/ou électriques, réutilisables.

Les éléments d'interconnexion forment un organe de sécurité, permettant d'interrompre ou limiter le courant électrique entre des plots conducteurs ou des zones conductrices, lorsque la température dépasse un certain seuil prédéterminé ou qu'un courant destiné à traverser ces éléments dépasse un certain seuil prédéterminé.

Les éléments d'interconnexion peuvent être connectés au dernier niveau métallique parmi lesdits niveaux métalliques d'interconnexion des composants.

Les éléments d'interconnexion peuvent être également agencés selon une matrice de X*Y éléments d'interconnexion (avec X et/ou Y des entiers supérieurs à 1) et comportant une ou plusieurs rangées verticales et une ou plusieurs rangées horizontales d'éléments d'interconnexion.

Selon une possibilité, la matrice peut être formée d'une pluralité d'autres éléments d'interconnexions orthogonaux au plan principal du substrat, traversant ladite couche isolante, lesdits autres éléments étant à base d'un matériau du circuit électronique susceptible d'atteindre une température supérieure à un seuil prédéterminé lorsque le dispositif fonctionne dans une gamme de courants donnée, peut être effectuée.

Les éléments à base de matériau polymère conducteur à coefficient de température positif sont alors disposés à l'étape b) en fonction de ladite zone d'échauffement localisée.

Les éléments à base de polymère conducteur à coefficient de température positif, peuvent être formés sur une première zone conductrice, et prévus pour relier électriquement la première zone conductrice à une deuxième zone conductrice. Le procédé peut comprendre préalablement à l'étape b), ou à l'étape a), ou à la fabrication du dispositif, une étape de détermination d'au moins un courant maximal destiné à circuler entre la première zone conductrice et la deuxième zone conductrice, lorsque le dispositif fonctionne dans une gamme de températures donnée, le nombre d'éléments et la taille des éléments à base de polymère conducteur à coefficient de température positif formés à l'étape b), étant prévus en fonction de ladite valeur de courant maximal déterminée.

Selon un aspect de l'invention, on peut déterminer préalablement une valeur seuil de température à ne pas dépasser, lors du fonctionnement du dispositif, pour un ou plusieurs composants et/ou pour ladite pluralité d'éléments d'interconnexion ou pour au moins une partie de ladite pluralité d'éléments d'interconnexion, et on détermine le nombre et/ou la géométrie (en particulier au moins la section ou la longueur) desdits éléments d'interconnexion en fonction de ladite valeur seuil de température à ne pas dépasser.

Selon un autre aspect de l'invention, on peut déterminer préalablement une puissance maximale susceptible d'être dissipée par le dispositif, par exemple à une température seuil à ne pas dépasser, lors du fonctionnement de ce dispositif, et on détermine le nombre et/ou la géométrie (en particulier au moins la section ou la longueur) desdits éléments d'interconnexion en fonction de ladite valeur de puissance maximale.

Selon encore un autre aspect de l'invention, on peut déterminer préalablement une densité de courant admissible susceptible de traverser ladite pluralité d'éléments d'interconnexion, lors du fonctionnement de ce dispositif, et on détermine le nombre et/ou la géométrie (en particulier au moins la section ou la longueur) desdits éléments d'interconnexion en fonction de ladite valeur de densité de courant admissible.

L'invention concerne également un dispositif microélectronique comprenant :
- un substrat,
- une pluralité de composants formant un circuit électronique sur le substrat,
- une pluralité de niveaux métalliques superposés d'interconnexions des composants, lesdits niveaux métalliques étant situés dans au moins une couche isolante reposant sur le substrat,
- une pluralité d'éléments verticaux de connexion à base d'un matériau polymère conducteur à coefficient de température positif, lesdits éléments traversant une épaisseur de la couche isolante et étant connectés à au moins à une zone conductrice d'un niveau d'interconnexion donné.

Lesdits éléments peuvent être connectés à au moins à une autre zone conductrice d'un autre niveau d'interconnexion différent dudit niveau donné.

Les éléments à base de matériau polymère conducteur à coefficient de température positif peuvent être agencés selon une matrice.

La matrice peut comprendre des éléments conducteurs à base de matériau métallique.

Les éléments d'interconnexion à base de polymère conducteur à coefficient de température positif, peuvent être connectés au dernier niveau métallique parmi lesdits niveaux métallique d'interconnexion.

Les éléments à base d'un matériau polymère conducteur à coefficient de température positif peuvent relier et connecter électriquement une première zone conductrice et une deuxième zone conductrice. Le nombre et la taille des éléments d'interconnexion à base de matériau polymère conducteur à coefficient de température positif, peuvent être alors prévus de manière à :
- limiter le courant entre la première zone conductrice et une deuxième zone conductrice à une valeur de courant prédéterminée,
- et/ou de manière à limiter une température de fonctionnement à une valeur seuil de température à ne pas dépasser, lors du fonctionnement du dispositif, pour un ou plusieurs composants et/ou pour ladite pluralité d'éléments d'interconnexion ou pour au moins une partie de ladite pluralité d'éléments d'interconnexion,
- et/ou de manière à limiter la puissance susceptible d'être dissipée par le dispositif à une puissance maximale, par exemple à une température seuil à ne pas dépasser, lors du fonctionnement de ce dispositif,
- et/ou de manière à limiter une densité de courant admissible susceptible de traverser ladite pluralité d'éléments d'interconnexion, lors du fonctionnement de ce dispositif.

Les éléments à base de matériau polymère conducteur à coefficient de température positif peuvent être disposés au niveau d'une zone d'échauffement localisée prédéterminée du circuit électronique.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1C donnent des exemples de dispositif microélectronique suivant l'invention, doté d'une matrice d'éléments d'interconnexion à base de matériau polymère conducteur à CTP positif ;
- la figure 2, illustre un exemple de profil d'évolution de la résistivité d'un matériau polymère conducteur à CTP positif en fonction de la température ;
- la figure 3, donne différents exemples de profils d'évolution de la résistivité en fonction de la température, de différents types de matériaux polymères conducteurs à CTP positif ;
- les figures 4A-4D, illustrent un exemple de procédé de réalisation d'un dispositif microélectronique suivant l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un premier exemple de dispositif microélectronique, mis en oeuvre suivant l'invention, va à présent être décrit.

Ce dispositif est formé sur un substrat, par exemple semi-conducteur et comprend un ou plusieurs circuits électroniques intégrés, ainsi que plusieurs niveaux superposés d'interconnexions M₁, ..., Mₙ, du ou des circuits.

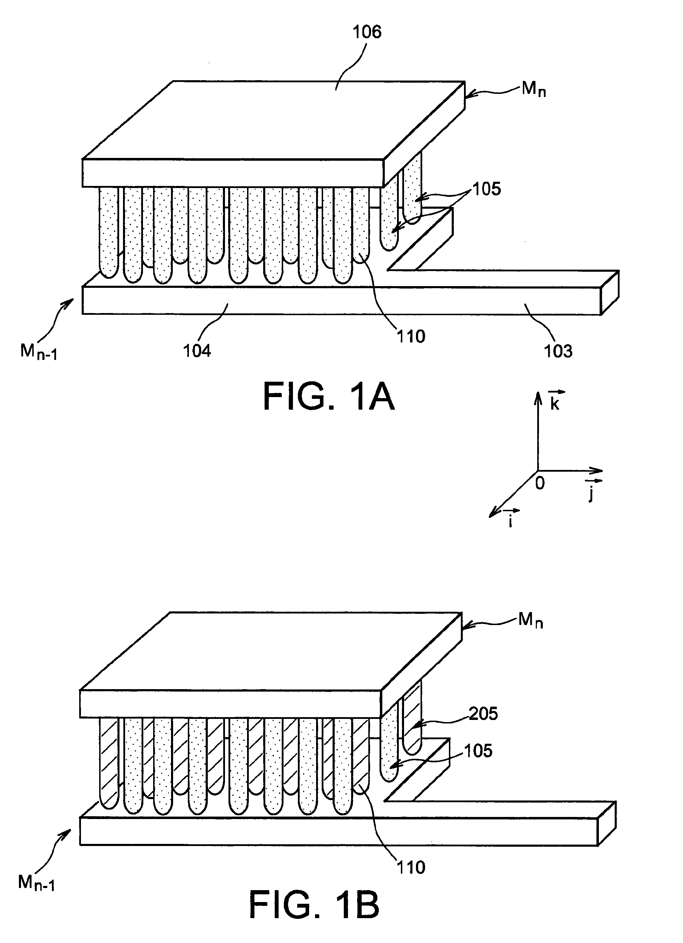

Chaque niveau d'interconnexion Mₖ peut être formé d'un ou plusieurs éléments de connexion horizontaux, c'est-à-dire des éléments parallèles ou sensiblement parallèles au plan principal du substrat (le plan principal du substrat étant un plan parallèle au plan [0; *i̅*; *j̅*] du repère orthogonal [0; *i̅*; *j̅*; *k̅*] donné sur les figures 1A-1C), et d'un ou plusieurs éléments de connexion verticaux, communément appelés « vias », perpendiculaires ou sensiblement perpendiculaires au plan principal du substrat.

Les éléments d'interconnexion sont situés dans une ou plusieurs couches isolantes formées sur le substrat (le substrat ainsi que la ou les couches isolantes n'étant pas représentés sur les figures 1A-1C).

Sur la figure 1A, un dernier niveau métallique Mₙ d'interconnexion d'un dispositif microélectronique est représenté et comporte une matrice de X*Y éléments d'interconnexion 105 verticaux, destinés à acheminer un courant entre un plot conducteur 106 du dernier niveau Mₙ, c'est-à-dire le plus éloigné du substrat, et un autre plot conducteur 104 d'un niveau inférieur, par exemple de l'avant dernier niveau métallique Mₙ₋₁.

Le plot conducteur 106 du dernier niveau Mn peut être relié à une ligne métallique horizontale (non représentée), par exemple à base de cuivre, tandis que le plot conducteur 104 de l'avant dernier niveau Mₙ₋₁ est relié à une autre ligne métallique horizontale 103.

Les éléments d'interconnexion 105 de la matrice sont formés d'un matériau 110 polymère conducteur à coefficient de température positif (ou PTC selon la terminologie anglo-saxonne pour « positive temperature coefficient »).

Le matériau polymère conducteur à coefficient de température positif peut être par exemple à base de Polyacéthylène (PA), du Polythiophène (PT), du Poly(3-alkyl)thiophène, du Polypyrrole (PPy), ou de la Polyaniline (PANi), et comporter des particules telles que des particules conductrices ou des particules de carbone.

Les éléments d'interconnexion 105 forment des moyens de protection, à utilisations multiples, à la fois contre des surintensités, et contre une surchauffe du dispositif.

Les éléments d'interconnexion 105 peuvent ainsi jouer le rôle de fusibles, thermiques et/ou électriques, réutilisables.

Les éléments d'interconnexion 105 forment un organe de sécurité, permettant de limiter ou d'interrompre le courant électrique entre les plots 104 et 106, lorsque la température dépasse un certain seuil prédéterminé ou qu'un courant destiné à traverser ces éléments dépasse un certain seuil prédéterminé.

Le nombre, la taille des éléments 105 d'interconnexion verticaux à base de matériau 110 sont prévus d'une part en tenant compte de la conductance du matériau polymère à CTP pour avoir une résistance inférieure ou égale à celle d'un plot classique métallique et d'autre part, de manière à définir un de courant maximal, que la matrice d'éléments est destinée à empêcher de véhiculer entre les plots 105, 106 ou que l'on souhaite admettre au maximum dans la ligne conductrice 103, la température dépendant de ce courant maximal, elle sera automatiquement limitée en fonction de la température critique du polymère conducteur à CTP.

Le nombre et la taille des éléments 105 d'interconnexion verticaux peuvent être prévus également en fonction d'une grandeur seuil de température que l'on ne souhaite pas dépasser.

La grandeur seuil de température dépend également de la loi d'évolution de la résistivité en température propre au matériau 110 polymère conducteur à coefficient de température positif que l'on a choisi.

A l'aide d'un logiciel tel que par exemple le logiciel ANSYS de la société ANSOFT, on peut déterminer par simulation, une puissance maximale susceptible d'être dissipée par le dispositif à la température seuil Tmax.

La puissance dissipée par les éléments 105 dépend d'une densité de courant traversant ces éléments. Ainsi, à partir d'une évaluation de cette densité de courant, en connaissant le profil de résistivité du polymère à CTP positif choisi, on détermine la hauteur, la section des éléments 105 d'interconnexion, ainsi que leur nombre.

Sur la figure 1B, une variante du dispositif de la figure 1A est donnée.

Dans cet exemple, la matrice d'éléments de connexion comporte une alternance d'éléments 105 à base de matériau 110 polymère conducteur à coefficient de température positif, et d'éléments 205 conducteurs à base d'un matériau métallique, par exemple tel que du Cuivre, ou du Tungstène, ou de l'Aluminium.

Dans ce cas, les éléments 105 de la matrice sont prévus pour acheminer un courant et sont susceptibles de jouer le rôle de fusibles réutilisables, tandis que les autres éléments 205 ont pour rôle d'acheminer un courant entre les plots 104 et 106.

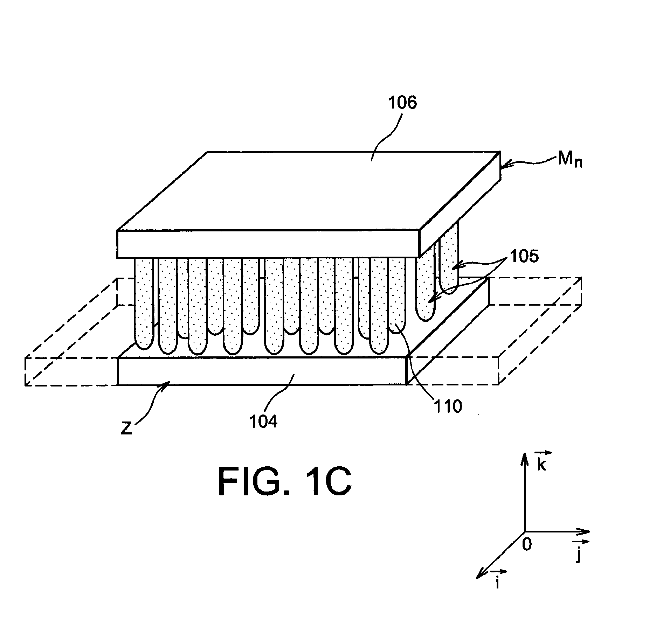

Sur la figure 1C, une autre variante du dispositif des figures 1A et 1B est donnée. La matrice d'éléments de connexion comporte des éléments de connexion 105 verticaux à base d'un matériau 110 polymère conducteur à coefficient de température positif, localisés sur une zone Z de connexion d'un composant ou connectée à un composant ou un circuit, et qui est a été déterminée comme une zone d'échauffement important de ce composant ou de ce circuit.

Le composant peut être par exemple un microprocesseur ou un circuit analogique fonctionnant à une fréquence élevée, ou une alimentation en tension.

La zone Z peut avoir été préalablement déterminée comme zone d'échauffement important par simulation par exemple à l'aide d'un logiciel tel que par exemple le logiciel ANSYS de la société ANSOFT, au cours de laquelle on identifie des zones du dispositif d'échauffement le plus important lorsque ce dernier est en fonctionnement. La zone Z peut avoir été préalablement déterminée comme une zone susceptible d'atteindre une certaine gamme de températures pour une gamme de courants donnée circulant dans le dispositif.

Dans ce cas, la zone, Z joue le rôle d'un capteur de température dont la résistance électrique pourra être utilisée par un circuit de régulation indépendant.

Dans l'un ou l'autre des exemples de dispositif qui viennent d'être donnés, un circuit de contrôle de la résistance de la matrice d'éléments 105 peut être prévu. Un tel circuit de contrôle peut être prévu pour détecter des augmentations de résistance de la matrice dues par exemple à une augmentation de la température globale. Un tel circuit peut être prévu pour limiter les courants d'alimentation d'un circuit intégré connecté à la matrice d'éléments d'interconnexion 105. Un tel circuit de contrôle peut être réalisé par exemple à l'aide d'une diode ou d'un transistor intégré.

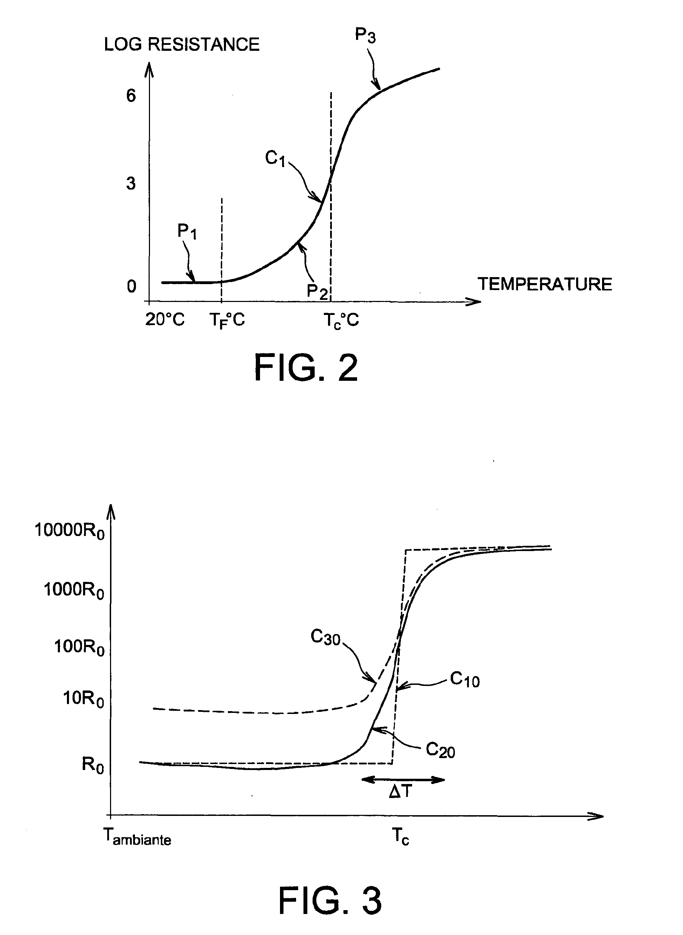

Un exemple de profil d'évolution de la résistivité d'un polymère conducteur à coefficient de température positif est donné sur la figure 2.

Sur cette figure la courbe C₁ de variation de la résistance du polymère conducteur à coefficient de température positif est exprimée en unité logarithmiques.

Cette courbe comporte une zone (portion P₁ de la courbe C₁) dite de « faible résistivité » dans laquelle, pour des températures inférieures à une température T_{F(°C)} appelée température normale de fonctionnement, le polymère conducteur a une faible résistivité évoluant peu en fonction de la température.

Cette courbe comporte ensuite une zone de croissance (portion P₂ de la courbe C₁) importante entre la température T_{F (°C)} et une température Tc (°C) appelée température caractéristique de transition, ainsi qu'au-delà de la température T°c. Puis, le polymère comporte (portion P₃ de la courbe C₁) une zone de forte résistivité pour des températures supérieures à une température Tc(°C).

Le dépassement d'une densité de courant admissible entraîne un échauffement du polymère. Le coefficient de température de la résistance du polymère étant positif, la résistance d'un élément de connexion 105 formé à base de ce polymère augmente, ce qui a tendance à faire chuter la tension aux extrémités des éléments de connexion 105, et à limiter le courant et sa densité de courant traversant la matrice d'éléments 105. La température des éléments de connexion 105 a tendance à décroître.

Si le dispositif est soumis à une température ambiante très élevée, par exemple de l'ordre de 125°C ou 150°C pour un microprocesseur, la densité de courant traversant la matrice est limitée par la résistance accrue du polymère et n'entraîne pas d'échauffement supplémentaire.

La matrice d'élément 105 est ainsi susceptible de fonctionner également en limiteur thermique et comme moyen de protection contre un emballement thermique.

La température caractéristique de transition Tc ainsi que le profil de résistivité dépendent de la nature et de la composition du polymère.

Ces paramètres peuvent être modulés en adaptant la charge en particules conductrices que contient le polymère conducteur.

La température caractéristique de transition Tc ainsi que le profil de résistivité du polymère conducteur à CTP (Coefficient de température positif) utilisé, peuvent être adaptés en fonction de l'application désirée pour le dispositif décrit en liaison avec les figures 1A-1C.

Des exemples différents de profils de résistivité en fonction de la température, de 3 matériaux polymères à coefficient de température positif différents sont donnés sur la figure 3.

Le premier exemple de profil (courbe C₁₀) est celui d'un premier polymère ayant une faible résistivité R0 lorsqu'inférieur à la température Tc, et une transition abrupte à partir de la température Tc, passant de R0 à 10000*R0.

Un tel polymère peut permettre d'assurer une fonction de disjoncteur, qui, dès lors qu'il atteint la température critique Tc augmente brusquement sa résistivité de manière à ne plus conduire de courant. Un polymère tel que le Polyethylène, l'ethylène, le propylène-diène, un terpolymère, chargé en carbone peut avoir un profil de ce type.

Le deuxième exemple de profil (courbe C₂₀) est celui d'un deuxième matériau polymère ayant une faible résistivité R0 et une transition plus progressive que dans le premier exemple, de sorte qu'une augmentation de résistivité, de R0 à 10000*R0, se fait dans une gamme de température ΔT de l'ordre de 5°C.

Le deuxième matériau peut permettre d'assurer une régulation en température. Dès lors qu'un tel matériau augmente en température et atteint une température dans la gamme ΔT, cela entraine une augmentation de résistivité de manière à induire une baisse du courant de la matrice d'éléments de connexion formés à base de ce matériau, ce qui a tendance à induire une baisse de température.

Le troisième exemple de profil (courbe C₃₀) est celui d'un troisième polymère ayant une résistivité plus importante en dessous de la température critique Tc et une transition plus progressive que dans les deux exemples précédents, de sorte qu'une augmentation de résistivité, de 10*R0 à 10000*R0, se fait dans une gamme de température ΔT de l'ordre de 5°C.

Une matrice d'éléments à base d'un tel polymère peut permettre d'assurer une régulation en température. Pour former une matrice à l'aide d'un tel polymère, on peut prévoir un nombre plus important d'éléments conducteurs 105 que pour une matrice formée à l'aide du deuxième polymère correspondant au deuxième exemple de profil.

Lorsque la densité de courant J traversant la matrice est telle, ou que la température des éléments 105 est telle que la température Tc n'est pas atteinte, les éléments 105 conduisent et leur résistivité varie peu.

Lorsque la densité de courant J traversant la matrice est telle, ou que la température des éléments 105 est telle, que la température de transition Tc est dépassée, cela induit une augmentation de la résistance de la matrice de connexion, l'augmentation créant une chute de tension et une baisse de la densité de courant traversant la matrice et parvenant jusqu'au plot 104, ce qui crée une baisse de la température des éléments 105 de la matrice, jusqu'à un équilibre thermique où l'échauffement des élément 105 et la dissipation générée par ces éléments 105 s'équilibre.

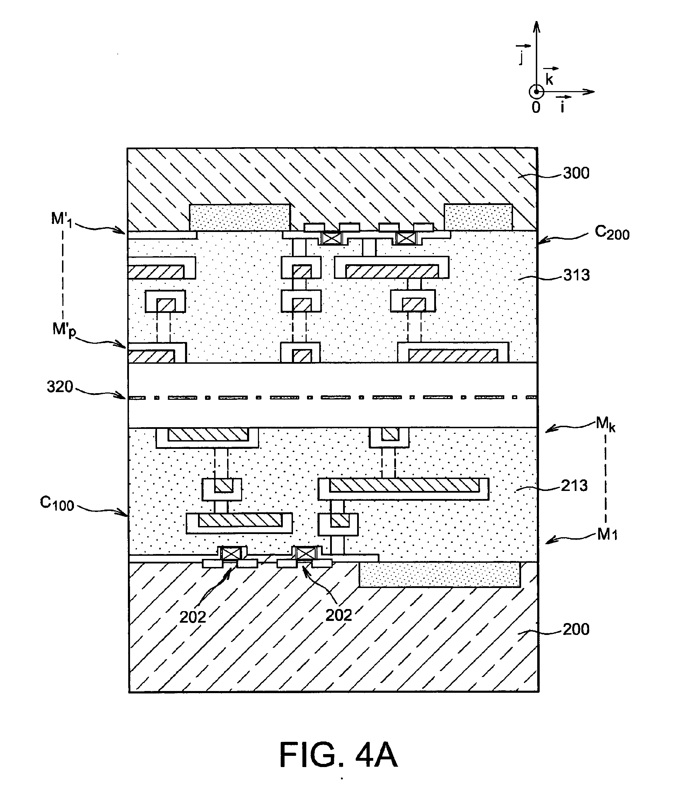

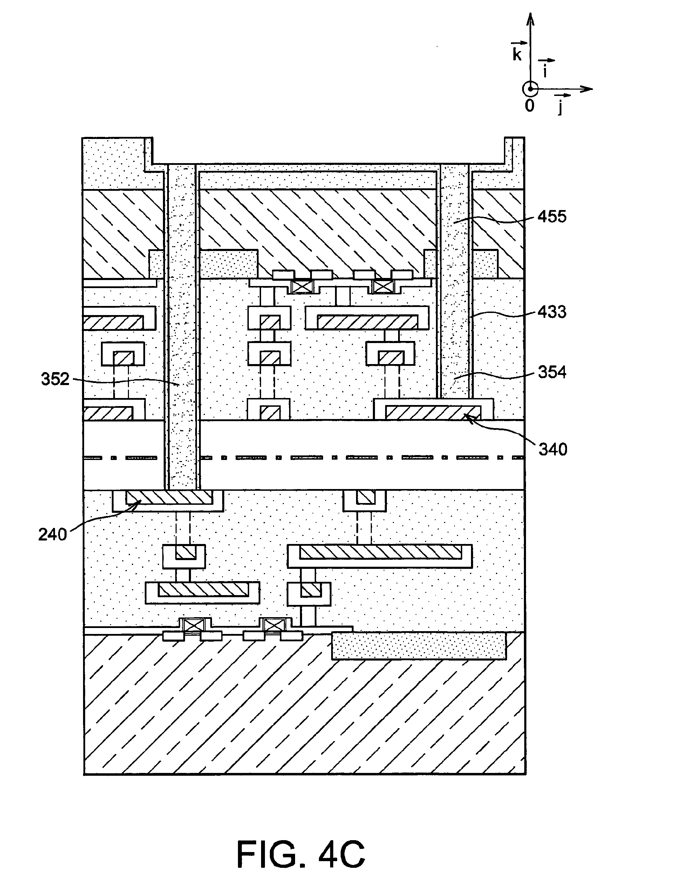

Un procédé de réalisation d'un dispositif microélectronique suivant l'invention, doté d'une pluralité de circuits superposés et d'éléments verticaux d'interconnexions appelés « supervias » formés à base d'un polymère conducteur à coefficient de température positif, va à présent être décrit en liaison avec les figures 4A-4D.

On réalise tout d'abord un dispositif comprenant une pluralité de circuits intégrés superposés.

Le dispositif comprend ainsi au moins un premier circuit C100 et au moins un deuxième circuit C200, formé au-dessus du premier circuit C100.

Les circuits C100, C200 peuvent être par exemple de l'un ou l'autre des types suivantes : électronique, RF, optoélectronique, logique, mémoire, MEMS, un ou plusieurs composants passifs.

Le dispositif que l'on réalise peut comporter au moins un premier circuit d'un premier type et au moins un deuxième circuit d'un type différent, choisis par exemple parmi les types de circuits précités.

Le premier circuit C100 est formé sur un substrat 200 et comporte une pluralité de composants 202, par exemple notamment des transistors, ainsi qu'une pluralité de k niveaux métalliques M1,...,Mk d'interconnexion des composants réalisés dans une couche isolante 213.

Le deuxième circuit C200 peut être formé sur un deuxième substrat 300 et peut comporter également une pluralité de composants 302, ainsi qu'une pluralité de p niveaux métalliques M'1,...,M'p d'interconnexion des composants 302, situés dans une couche isolante 313.

Le premier circuit C100 et le deuxième circuit C200 peuvent être formés indépendamment, puis assemblés, par exemple par un procédé de collage retournement dans lequel on retourne le deuxième substrat 300, on aligne les deux substrats 200, 300, l'un par rapport à l'autre puis on colle, par exemple par collage moléculaire les deux circuits C100, C200, l'un sur l'autre.

Une interface 320 de collage, qui peut être formée d'une épaisseur isolante, par exemple à base d'oxyde de silicium sépare les interconnexions des deux circuits C100 et C200 (figure 4A).

Ensuite on peut réaliser un amincissement du deuxième substrat 300, de manière à diminuer son épaisseur et ne conserver qu'une épaisseur qui peut être par exemple de l'ordre de plusieurs micromètres, par exemple de l'ordre de 15 µm à 30 µm.

Ensuite, une couche de matériau diélectrique 303, par exemple du SiO₂, peut être réalisée sur le deuxième substrat 200.

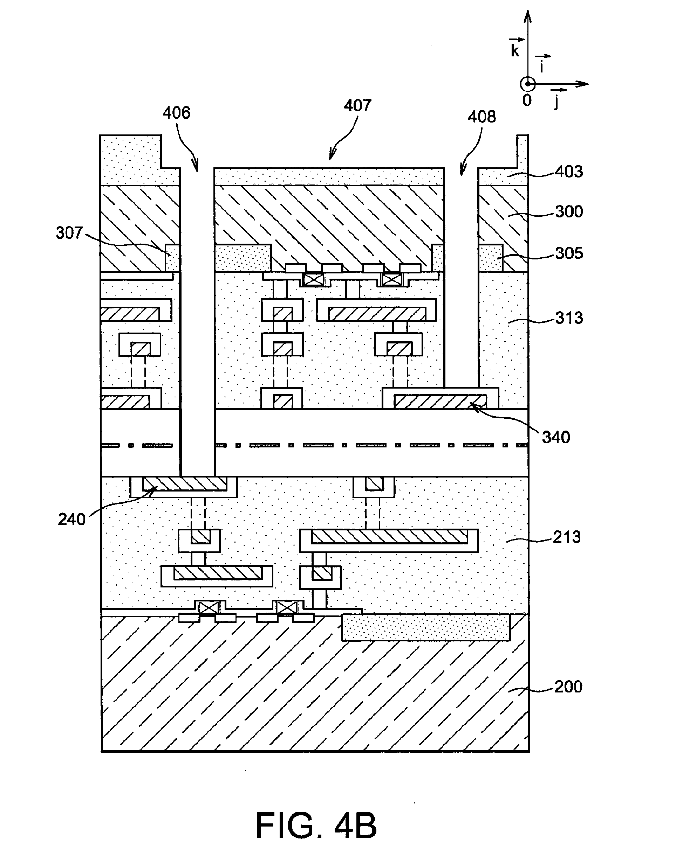

Puis (figure 4B), on forme des ouvertures 406, 408 traversant notamment ledit deuxième substrat 300, la couche isolante 313, l'interface de collage 220.

Les ouvertures 406, 408 peuvent être réalisées par exemple par photolithographie et gravure et débouchent respectivement sur au moins une zone métallique 240 du premier circuit C100 et sur au moins une zone métallique 340 du deuxième circuit C200.

Une ou plusieurs tranchées parallèles au plan principal du substrat (défini sur la figure 4B comme un plan passant par le substrat et parallèle au plan [○; *̅i̅*̅; *̅j̅*̅] du repère orthogonal [○;*̅i̅*̅; *̅j̅*̅; *̅k̅*̅]) peuvent également être formées dans la couche de matériau diélectrique 403, dont au moins une tranchée 407 dévoilant l'embouchure des ouvertures 406 et 408.

Les ouvertures 406, 408 peuvent être agencées de manière à traverser des zones d'isolation 305 STI (STI pour « shallow trench isolation ») du deuxième circuit C200.

Les ouvertures 406, 408 peuvent avoir un diamètre D (mesuré sur la figure 4B dans une direction parallèle au vecteur *̅j̅*̅ du repère orthogonal [○; *̅i̅*̅; *̅j̅*̅; *̅k̅*̅]) compris par exemple entre 1 et 5 µm ou entre 5 et 10 µm.

Les ouvertures 406, 408 peuvent également avoir une hauteur H (mesurée sur la figure 4B dans une direction parallèle au vecteur *̅k̅*̅ du repère orthogonal [○; *̅i̅*̅; *̅j̅*̅; *̅k̅*̅]) compris par exemple entre 15 µm et 20 µm ou entre 15 µm et 30 µm.

Les ouvertures 406, 408 peuvent être ainsi éventuellement prévues avec des dimensions plus élevées que celles (resp. ceux) des vias des dispositifs classiques.

Ensuite, on forme une fine couche isolante 433 sur les parois des ouvertures 406, 408, de manière à recouvrir des parties du deuxième substrat 300 dévoilées par les ouvertures 406, 407.

Une telle fine couche isolante 433 peut permettre d'empêcher de mettre les vias qui sont destinés à être réalisés dans les ouvertures 406, 408 en court circuit avec le substrat 300.

Une telle fine couche isolante 433 peut être par exemple à base d'un diélectrique tel que du SiO₂.

Puis, on effectue un remplissage des ouvertures 406, 408 à l'aide d'un matériau polymère conducteur 455 à coefficient de température positif.

Le polymère conducteur à coefficient de température positif peut être à base de polyaniline ou formé d'un matériau organique à base de carbone ayant des propriétés conductrices naturelles ou obtenues par dopage.

Le remplissage peut être effectué à une température inférieure à 200°C.

Le polymère conducteur peut être par exemple formé par dépôt CVD (CVD pour « Chemical Vapor Deposition ») ou PVD (PVD pour « Physical Vapor Deposition ». La technique de remplissage est adaptée en fonction de la taille des ouvertures 406, 408, à remplir et du facteur de forme de ces dernières.

Pour des facteurs de forme entre 5 et 10, la viscosité du polymère conducteur peut être adaptée entre 1 et 10⁴ Ctps et jusqu'à des facteurs de forme (rapport hauteur sur largeur des motifs) la viscosité du polymère peut être comprise entre 10⁴ et 10⁵ centipoises.

Le remplissage peut être éventuellement suivi d'une étape de polissage mécano-chimique CMP.

Un recuit thermique ou par UV peut permettre de faire fluer la couche déposée et éliminera les solvants résiduels et de réorganiser la structure chimique du polymère.

Avec le dépôt d'un tel polymère, on peut se prémunir d'étapes de réalisation d'un empilement de couches telles que des couches de barrière de diffusion ou d'accrochage lorsque les interconnexions sont à base de cuivre. Le polymère conducteur, bien qu'ayant une conductivité plus faible que le cuivre, est particulièrement adapté à la réalisation de vias de dimension importantes ou de rapport de formes importants.

Après remplissage, on a formé un premier élément d'interconnexion à base de matériau polymère 455 la première ouverture dévoile une première zone conductrice 240 connectée à un des niveaux métalliques M1...,Mk du premier circuit et au moins une deuxième ouverture dévoile une deuxième zone conductrice 340 connectée à un des niveaux métalliques M'1...,M'p du deuxième circuit C200, ledit remplissage conduisant à la formation d'au moins un premier élément 352 à base du matériau donné 455 connecté à la première zone conductrice 240 et d'au moins un deuxième élément 354 à base du matériau donné connecté à la deuxième zone conductrice 340.

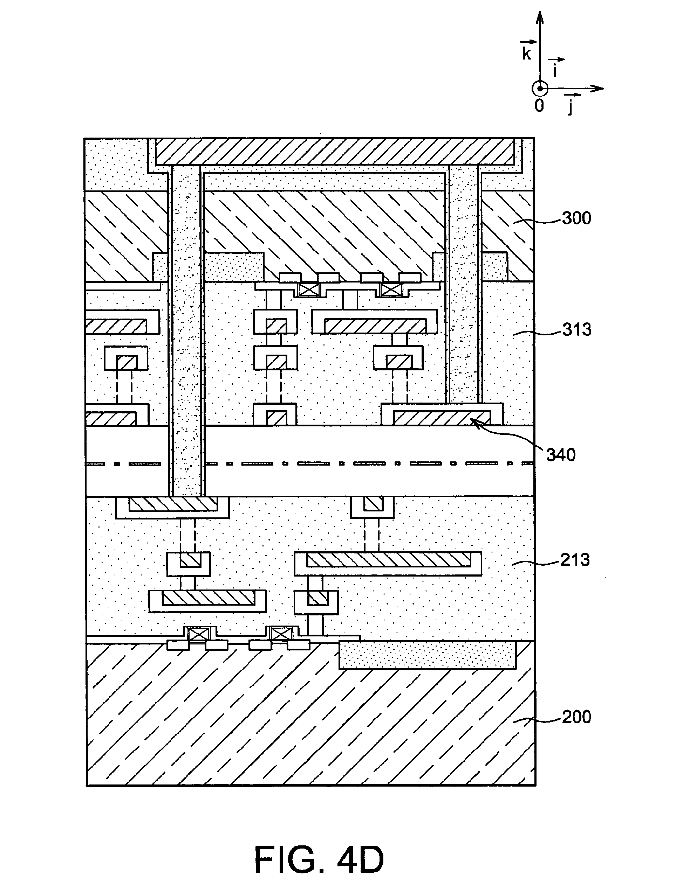

Ensuite, la tranchée 407 est comblée à l'aide d'un matériau métallique par exemple tel que du cuivre (figure 4D).

Dans un dispositif et un procédé selon l'invention, on peut prendre un Métal (par exemple du platine) au lieu du polymère en tant que matériau CTP.

Dans un dispositif et un procédé selon l'invention, ce matériau CTP est disposé à l'intérieur de la puce microélectronique, à un endroit de la puce endroit où un des composant va par exemple chauffer. Le matériau CTP permet de réguler son fonctionnement par détection et régulation de température.

Le matériau à CTP est mis en oeuvre selon l'invention aux endroits de la puce qui nécessitent un refroidissement, et/ou une régulation et/ou une limitation en température. On peut calculer la taille et le nombre de vias en tenant compte de la conductance du matériau CTP utilisé pour obtenir le seuil de déclenchement en fonction de la densité de courant maximale admissible ou de la puissance maximale dissipée dans les lignes à protéger.

Selon l'invention on n'utilise pas le matériau CTP comme fusible à action unique (c'est-à-dire que quand le fusible s'est déclenché, on ne revient pas en arrière) mais pour ses propriétés réenclenchables, à savoir que l'on revient à l'état initial si la protection n'est plus nécessaire, c'est-à-dire une fois que la température et/ou la densité de courant et/ou la puissance dissipée revient à une valeur inférieure à la valeur seuil correspondante.. Une fois de plus, le matériau est intégré dans la puce et déposé là où il va permettre de lutter contre les surchauffes.

La grandeur seuil de température (ou de puissance dissipée ou de densité de courant) dépend également de la loi d'évolution de la résistivité en température propre au matériau à CTP que l'on a choisi.

Selon l'invention on peut déterminer par simulation, une puissance maximale susceptible d'être dissipée par le dispositif à une température seuil Tmax.

La puissance dissipée par les éléments 105 dépend d'une densité de courant traversant ces éléments. Ainsi, à partir d'une évaluation de cette densité de courant, en connaissant le profil de résistivité du matériau à CTP positif choisi, on détermine la hauteur, la section des éléments 105 d'interconnexion, ainsi que leur nombre.

## Revendications

1. Procédé de réalisation d'un dispositif microélectronique comprenant sa fabrication par :
a) réalisation sur un substrat d'un ou plusieurs composants d'au moins un circuit électronique et d'un ou plusieurs niveaux métalliques d'interconnexion du circuit électronique dans au moins une couche isolante,
b) réalisation d'une pluralité d'éléments d'interconnexions (105) orthogonaux au plan principal du substrat, traversant ladite couche isolante, lesdits éléments (105) étant à base d'un matériau (110) polymère conducteur à coefficient de température positif,
**caractérisé en ce que** ledit procédé comportant en outre, préalablement à l'étape b), ou à l'étape a) ou à la fabrication du dispositif, une étape de détermination d'au moins une zone (Z) d'échauffement du circuit électronique susceptible d'atteindre une température supérieure à un seuil prédéterminé lorsque le dispositif fonctionne dans une gamme de courant donnée, les éléments étant disposés à l'étape b) en fonction de ladite au moins une zone d'échauffement localisée.

2. Procédé selon la revendication 1, dans lequel les éléments d'interconnexion (105) sont connectés au dernier niveau métallique parmi lesdits niveaux métalliques d'interconnexion des composants.

3. Procédé selon l'une des revendications 1 ou 2, dans lequel les éléments (105) d'interconnexion sont agencés en matrice.

4. Procédé selon l'une des revendications 1 à 3, la matrice étant formée en une pluralité d'autres éléments d'interconnexions (205) orthogonaux au plan principal du substrat, traversant ladite couche isolante, lesdits autres éléments (205) étant à base d'un matériau métallique.

5. Procédé selon l'une des revendications 1 à 4, dans lequel les éléments à base de polymère conducteur à coefficient de température positif, sont formés sur une première zone conductrice (104), et prévus pour relier électriquement la première zone conductrice à une deuxième zone conductrice (106), le procédé comprenant préalablement à l'étape b), ou à l'étape a) ou à la fabrication du dispositif, une étape de détermination d'au moins un courant maximal destiné à circuler entre la première zone conductrice et la deuxième zone conductrice, lorsque le dispositif fonctionne dans une gamme de températures donnée, le nombre d'éléments et la taille des éléments à base de polymère conducteur à coefficient de température positif formés à l'étape b), étant prévus en fonction de ladite valeur.

6. Procédé selon l'une des revendications 1 à 5, dans lequel on détermine préalablement une valeur seuil de température à ne pas dépasser pour un ou de plusieurs composants ou pour au moins une partie de ladite pluralité d'éléments d'interconnexion, et on détermine le nombre et/ou la géométrie desdits éléments d'interconnexion en fonction de ladite valeur seuil de température.

7. Procédé selon l'une des revendications 1 à 6, dans lequel on détermine préalablement une puissance maximale susceptible d'être dissipée par le dispositif lors du fonctionnement de ce dispositif, et on détermine le nombre et/ou la géométrie desdits éléments d'interconnexion en fonction de ladite valeur de puissance maximale.

8. Procédé selon l'une des revendications 1 à 7, dans lequel on détermine préalablement une densité de courant admissible susceptible de traverser ladite pluralité d'éléments d'interconnexion, lors du fonctionnement de ce dispositif, et on détermine le nombre et/ou la géométrie desdits éléments d'interconnexion en fonction de ladite valeur de densité de courant admissible.

9. Dispositif microélectronique comprenant :
- un substrat
- une pluralité de composants formant un circuit électronique sur le substrat,
- un ou plusieurs niveaux métalliques superposés d'interconnexions des composants, lesdits niveaux métalliques étant situés dans au moins une couche isolante reposant sur le substrat,
- une pluralité d'éléments (105) d'interconnexion orthogonaux au plan principal du substrat et à base d'un matériau (110) polymère conducteur à coefficient de température positif, lesdits éléments traversant une épaisseur de la couche isolante et étant connectés à au moins une ligne conductrice d'un niveau d'interconnexion donné, **caractérisé en ce que** les éléments à base de matériau polymère conducteur à coefficient de température positif étant disposés au niveau d'une zone d'échauffement localisée prédéterminée du circuit électronique.

10. Dispositif selon la revendication 9, dans lequel les éléments à base de matériau (110) polymère conducteur à coefficient de température positif sont agencés selon une matrice.

11. Dispositif selon l'une des revendications 9 ou 10, la matrice comprenant en outre des éléments (205) conducteurs à base de matériau métallique.

12. Dispositif selon l'une des revendications 9 à 11, dans lequel les éléments d'interconnexion (105) à base de polymère conducteur à coefficient de température positif, sont connectés au dernier niveau métallique parmi lesdits niveaux métallique d'interconnexion.

13. Dispositif selon l'une des revendications 9 à 12, dans lequel les éléments (105) à base d'un matériau polymère conducteur à coefficient de température positif relient et connectent électriquement une première zone conductrice (104) et une deuxième zone conductrice (106), le nombre et la taille éléments d'interconnexion (105) à base de matériau (110) polymère conducteur à coefficient de température positif, étant prévus :
- de manière à limiter le courant entre la première zone conductrice (104) et une deuxième zone conductrice (106) à une valeur de courant prédéterminée ;
- et/ou de manière à limiter une température de fonctionnement à une valeur seuil de température à ne pas dépasser, lors du fonctionnement du dispositif, pour un ou plusieurs composants et/ou pour ladite pluralité d'éléments d'interconnexion ou pour au moins une partie de ladite pluralité d'éléments d'interconnexion,
- et/ou de manière à limiter la puissance susceptible d'être dissipée par le dispositif à une puissance maximale, par exemple à une température seuil à ne pas dépasser, lors du fonctionnement de ce dispositif,
- et/ou de manière à limiter une densité de courant admissible susceptible de traverser ladite pluralité d'éléments d'interconnexion, lors du fonctionnement de ce dispositif.

14. Dispositif selon l'une des revendications 9 à 13, comportant en outre un circuit de contrôle de la résistance des éléments (105) d'interconnexion.

15. Dispositif selon la revendication 14, le circuit de contrôle permettant de détecter des augmentations de résistance des éléments (105) d'interconnexion dues à une augmentation de la température globale.

16. Dispositif selon la revendication 14 ou 15, le circuit de contrôle permettant de limiter les courants d'alimentation d'un circuit intégré connecté aux éléments d'interconnexion (105).

## Patentansprüche

1. Verfahren zur Herstellung einer mikroelektronischen Einrichtung, umfassend deren Anfertigung, durch:
a) Herstellung, auf einem Substrat, von einer oder mehreren Komponenten von wenigstens einem elektronischen Schaltkreis und von einem oder mehreren metallischen Verbindungsniveaus des elektronischen Schaltkreises in wenigstens einer isolierenden Schicht,
b) Herstellung einer Mehrzahl von zu der Hauptebene des Substrats orthogonalen Verbindungselementen (105), welche die isolierende Schicht durchqueren, wobei die Elemente (105) auf einem leitfähigen Polymermaterial (110) mit positivem Temperaturkoeffizienten basieren, **dadurch gekennzeichnet, dass** das Verfahren weiterhin, vor dem Schritt b) oder dem Schritt a) oder der Anfertigung der Einrichtung, einen Schritt der Bestimmung von wenigstens einem Erwärmungsbereich (Z) des elektronischen Schaltkreises umfasst, der dazu geeignet ist, eine Temperatur zu erreichen, die oberhalb von einem vorbestimmten Schwellenwert liegt, wenn die Einrichtung in einem gegebenen Strom-Bereich arbeitet, wobei die Elemente im Schritt b) in Abhängigkeit von dem wenigstens einen lokalisierten Erwärmungsbereich angeordnet werden.

2. Verfahren nach Anspruch 1, wobei die Verbindungselemente (105) mit dem letzten metallischen Niveau unter den metallischen Verbindungsniveaus der Komponenten verbunden werden.

3. Verfahren nach einem der Ansprüche 1 oder 2, wobei die Verbindungselemente (105) als Matrix angeordnet werden.

4. Verfahren nach einem der Ansprüche 1 bis 3, wobei die Matrix aus einer Mehrzahl von anderen, zu der Hauptebene des Substrats orthogonalen Verbindungselementen (205) gebildet wird, welche die isolierende Schicht durchqueren, wobei die anderen Elemente (205) auf einem metallischen Material basieren.

5. Verfahren nach einem der Ansprüche 1 bis 4, wobei die Elemente auf Basis von einem leitfähigen Polymer mit positivem Temperaturkoeffizienten auf einem ersten leitfähigen Bereich (104) ausgebildet werden und vorgesehen sind, um den ersten leitfähigen Bereich elektrisch mit einem zweiten leitfähigen Bereich (106) zu verbinden, wobei das Verfahren, vor dem Schritt b) oder dem Schritt a) oder der Anfertigung der Einrichtung, einen Schritt der Bestimmung von wenigstens einem maximalen Strom umfasst, der dazu bestimmt ist, zwischen dem ersten leitfähigen Bereich und dem zweiten leitfähigen Bereich zu zirkulieren, wenn die Einrichtung in einem gegebenen Temperaturbereich arbeitet, wobei die Anzahl von Elementen und die Größe der Elemente auf Basis eines leitfähigen Polymers mit positivem Temperaturkoeffizienten, die im Schritt b) gebildet werden, in Abhängigkeit von diesem Wert vorgesehen werden.

6. Verfahren nach einem der Ansprüche 1 bis 5, wobei zuvor für eine oder mehrere Komponenten oder für wenigstens einen Teil der Mehrzahl von Verbindungselementen ein nicht zu überschreitender Temperatur-Schwellenwert bestimmt wird, und die Anzahl oder/und die Geometrie der Verbindungselemente in Abhängigkeit von dem Temperatur-Schwellenwert bestimmt wird.

7. Verfahren nach einem der Ansprüche 1 bis 6, wobei zuvor eine maximale Leistung bestimmt wird, die dazu geeignet ist, von der Einrichtung bei dem Betrieb dieser Einrichtung dissipiert zu werden, und die Anzahl und/oder die Geometrie der Verbindungselemente in Abhängigkeit von dem Wert der maximalen Leistung bestimmt wird.

8. Verfahren nach einem der Ansprüche 1 bis 7, wobei zuvor eine zulässige Stromdichte bestimmt wird, die dazu geeignet ist, beim Betrieb dieser Einrichtung die Mehrzahl von Verbindungselementen zu durchqueren, und die Anzahl oder/und die Geometrie der Verbindungselemente in Abhängigkeit von dem Wert der zulässigen Stromdichte bestimmt wird.

9. Mikroelektronische Einrichtung, umfassend:
- ein Substrat,
- eine Mehrzahl von Komponenten, die einen elektronischen Schaltkreis auf dem Substrat bilden,
- ein oder mehrere, übereinander angeordnete metallische Verbindungsniveaus der Komponenten, wobei die metallischen Niveaus sich in wenigstens einer auf dem Substrat ruhenden isolierenden Schicht befinden,
- eine Mehrzahl von Verbindungselementen (105), die orthogonal zur Hauptebene des Substrats sind und auf einem leitfähigen Polymermaterial (110) mit positivem Temperaturkoeffizienten basieren, wobei die Elemente eine Dicke der isolierenden Schicht durchqueren und mit wenigstens einer Leiterbahn von einem gegebenen Verbindungsniveau verbunden sind,
**dadurch gekennzeichnet, dass** die Elemente auf Basis eines leitfähigen Polymermaterials mit positivem Temperaturkoeffizienten auf Höhe von einem vorbestimmten lokalisierten Erwärmungsbereich des elektronischen Schaltkreises angeordnet sind.

10. Einrichtung nach Anspruch 9, wobei die Elemente auf Basis eines leitfähigen Polymermaterials (110) mit positivem Temperaturkoeffizienten als Matrix angeordnet sind.

11. Einrichtung nach einem der Ansprüche 9 oder 10, wobei die Matrix weiterhin leitfähige Elemente (205) auf Basis eines metallischen Materials umfasst.

12. Einrichtung nach einem der Ansprüche 9 bis 11, wobei die Verbindungselemente (105) auf Basis eines leitfähigen Polymers mit positivem Temperaturkoeffizienten mit dem letzten metallischen Niveau unter den metallischen Verbindungsniveaus verbunden sind.

13. Einrichtung nach einem der Ansprüche 9 bis 12, wobei die Elemente (105) auf Basis eines leitfähigen Polymermaterials mit positivem Temperaturkoeffizienten einen ersten leitfähigen Bereich (104) und einen zweiten leitfähigen Bereich (106) aneinander anschließen und elektrisch verbinden, wobei die Anzahl und die Größe der Verbindungselemente (105) auf Basis eines leitfähigen Polymermaterials (110) mit positivem Temperaturkoeffizienten so vorgesehen sind, dass:
- der Strom zwischen dem ersten leitfähigen Bereich (104) und einem zweiten leitfähigen Bereich (106) auf einen vorbestimmten Stromwert begrenzt wird,
- oder/und eine Betriebstemperatur auf einen beim Betrieb der Einrichtung nicht zu überschreitenden Temperatur-Schwellenwert beschränkt wird, für eine oder mehrere Komponenten oder/und für die Mehrzahl von Verbindungselementen oder für wenigstens einen Teil der Mehrzahl von Verbindungselementen,
- oder/und die Leistung, die dazu geeignet ist, von der Einrichtung dissipiert zu werden, auf eine maximale Leistung begrenzt wird, beispielsweise bei einer beim Betrieb der Einrichtung nicht zu überschreitenden Schwellen-Temperatur,
- oder/und eine zulässige Stromdichte begrenzt wird, die dazu geeignet ist, die Mehrzahl von Verbindungselementen beim Betrieb der Einrichtung zu durchqueren.

14. Einrichtung nach einem der Ansprüche 9 bis 13, weiterhin umfassend einen Schaltkreis zur Steuerung/Regelung des Widerstands der Verbindungselemente (105).

15. Einrichtung nach Anspruch 14, wobei der Steuer-/Regelschaltkreis es erlaubt, Vergrößerungen des Widerstands der Verbindungselemente (105) aufgrund einer Vergrößerung der Gesamt-Temperatur zu erfassen.

16. Einrichtung nach Anspruch 14 oder 15, wobei der Steuer-/Regelschaltkreis es erlaubt, die Versorgungsströme für einen integrierten Schaltkreis zu begrenzen, der mit den Verbindungselementen (105) verbunden ist.

## Claims

1. A method for production of a microelectronic device including its manufacture by:
a) production on a substrate of one or more components of at least one electronic circuit, and of one or more metal levels of interconnection of the electronic circuit in at least one insulating layer,
b) production of multiple interconnection elements (105) orthogonal to the principal plane of the substrate, traversing the said insulating layer, where the said elements (105) are made from a positive temperature coefficient conductive polymer material (110), **characterised in that**
this method further includes, prior to step b), or to step a) or to the manufacture of the device, a step of determination of at least one zone (Z) of heating of the electronic circuit which can reach a temperature higher than a predetermined threshold when the device is operating within a given current range, and where the elements are positioned in step b) in accordance with the said at least one localised heating zone.

2. A method according to claim 1, in which the interconnection elements (105) are connected to the final metal layer from among the said metal layers of interconnection of the components.

3. A method according to one of the claims 1 or 2, in which the interconnection elements (105) are arranged in an array.

4. A method according to one of the claims 1 to 3, where the said array is formed from multiple other interconnection elements (205) which are orthogonal to the principal plane of the substrate, traversing the said insulating layer, where the said other elements (205) are made from a metal material.

5. A method according to one of the claims 1 to 4, in which the elements made from positive temperature coefficient conductive polymer are formed in a first conductive zone (104), and designed to connect electrically the first conductive zone to a second conductive zone (106), where the method includes, prior to step b), or to step a), or to the manufacture of the device, a step of determination of at least one maximum current intended to flow between the first conductive zone and the second conductive zone, when the device is operating within a given range of temperatures, and where the number of elements and the size of the elements made from positive temperature coefficient conductive polymer, formed in step b), are chosen according to the said value.

6. A method according to one of the claims 1 to 5, in which a threshold temperature value which must not be exceeded for one or more components, or for at least a portion of the said multiple interconnection elements, is determined beforehand, and in which the number and/or geometry of the said interconnection elements is (are) determined according to the said threshold temperature value.

7. A method according to one of the claims 1 to 6, in which a maximum power able to be dissipated by the device during operation of this device is determined beforehand, and in which the number and/or the geometry of the said interconnection elements is (are) determined according to the said maximum power value.

8. A method according to one of the claims 1 to 7, in which an acceptable current density which can traverse said multiple interconnection elements during operation of this device is determined beforehand, and in which the number and/or the geometry of the said interconnection elements is (are) determined according to the said acceptable current density value.

9. A microelectronic device including:
- a substrate
- multiple components forming an electronic circuit on the substrate,
- one or more superimposed metal levels of interconnections of the components, where the said metal levels are located in at least one insulating layer resting on the substrate,
- multiple interconnection elements (105) orthogonal to the principal plane of the substrate and made from a positive temperature coefficient conductive polymer material (110), where the said elements traverse a thickness of the insulating layer and are connected to at least one conductive line of a given interconnection level, **characterised in that** the elements made from a positive temperature coefficient conductive polymer material are positioned in a predetermined localised heating zone of the electronic circuit.

10. A device according to claim 9, in which the elements made from positive temperature coefficient conductive polymer material (110) are arranged in an array.

11. A device according to one of the claims 9 or 10, where the array also includes conductive elements (205) made from a metal material.

12. A device according to one of the claims 9 to 11, in which the interconnection elements (105) made from positive temperature coefficient conductive polymer are connected to the final metal level from among the said metal interconnection levels.

13. A device according to one of the claims 9 to 12, in which the elements (105) made from a positive temperature coefficient conductive polymer material link and connect electrically a first conductive zone (104) and a second conductive zone (106), where the number and the size of the interconnection elements (105) made from positive temperature coefficient conductive polymer material (110) are chosen:
- so as to restrict the current between the first conductive zone (104) and a second conductive zone (106) to a predetermined current value;
- and/or so as to restrict an operating temperature to a threshold temperature value which must not be exceeded, whilst the device is in operation, for one or more components and/or for the said multiple interconnection elements or for at least a portion of the said multiple interconnection elements,
- and/or so as to restrict the power which can be dissipated by the device at maximum power, for example to a threshold temperature which must not be exceeded, whilst this device is in operation,
- and/or so as to restrict an acceptable current density which can traverse the said multiple interconnection elements, when this device is in operation.

14. A device according to one of the claims 9 to 13, also including a circuit for controlling the resistance of the interconnection elements (105).

15. A device according to claim 14, where the control circuit enables increases in resistance of the interconnection elements (105) due to an increase of the overall temperature to be detected.

16. A device according to claim 14 or 15, where the control circuit enables the power currents of an integrated circuit connected to the interconnection elements (105) to be restricted.
